# EUROPÄISCHE PATENTSCHRIFT

(11) **EP 2 073 273 B1**
(45) Veröffentlichungstag und Bekanntmachung des Hinweises auf die Patenterteilung: **16.09.2015**
(21) Anmeldenummer: 08020121.3
(22) Anmeldetag: 19.11.2008
(51) Int. Cl.: H01L 29/861, H01L 21/329, H01L 29/417, H01L 29/06

(54) **Leistungsdiode mit grabenförmiger Feldringstruktur**
Power diode with trench field ring structure
Diode de puissance à anneau de garde en tranchée

(30) Priorität: 21.12.2007 DE 102007062305
(43) Veröffentlichungstag der Anmeldung: 24.06.2009
(73) Patentinhaber: Semikron Elektronik GmbH & Co. KG Patentabteilung, 90431 Nürnberg (DE)
(72) Erfinder: König, Bernhard, 90765 Fürth (DE)

(56) Entgegenhaltungen:
- WO-A-02/25740
- JP-A- S5 975 658
- US-A1- 2006 170 075

## Beschreibung

Die Erfindung beschreibt ein als Leistungsdiode ausgebildetes Leistungshalbleiterbauelement mit mindestens einem pn- Übergang, für Anwendungen in Stromrichtern der Leistungsklasse.

Gemäß dem Stand der Technik ist es bekannt im Randbereich des Leistungshalbleiterbauelements eine konzentrische Struktur aus einer Mehrzahl von Feldringen anzuordnen. Hierbei ist es bekannt diese Feldringe durch einen Diffusionsprozess zu erzeugen, wobei ein Dotierstoff maskiert auf der Oberfläche aufgebracht und anschießend durch Temperatureinwirkung in den Halbleiterkörper eindiffundiert wird, wodurch ein Diffusionsprofil ausgebildet wird. Für volumenleitfähige Leistungshalbleiterbauelemente ist es hierbei üblich die Feldringe gemeinsam mit der Erzeugung eines pn- Übergangs auszubilden, der den aktiven (stromführenden) Bereich der Diode darstellt.

Die WO 02/25740 A offenbart eine Hochvolt-Diode sowie ein Verfahren zu deren Herstellung, bei denen unter Verwendung von Justage-Strukturen und eines Chip-Stoppers mit einer Randpassivierung aus a-C:H oder a-Si nur drei Maskenschritte benötigt werden. Die Justage-Struktur wird durch eine Ausnehmung erzeugt, die in den Grundkörper hineinreicht und dadurch eine Kante ausbildet.

Die US 2006/0170075 A1 offenbart einen Halbleiter insbesondere eine Diode, die eine niedrige Durchlassspannungsabfall und eine Schutzeinrichtung bei entgegengesetztem Stromverlauf aufweist. Die Offenlegungsschrift weist einen Grundkörper mit Dotierung an einem ersten Teilbereich und einem zweiten Teilbereich.

Die JP 59-075658 A beschreibt ihrerseits ein Verfahren zur Verbesserung der Spannungsfestigkeit einer Diode, wobei ein Feldring mit einer Ausnehmung versehen ist und zusätzlich dessen Krümmung erhöht ist.

Da hier eine tiefe Diffusion des Dotierstoffes notwendig ist ergeben sich lange Diffusionszeiten und dadurch ist die Gefahr der Verunreinigung, beispielhaft durch Schwermetalle, des Diffusionsgebiets gegeben.

Der Erfindung liegt die Aufgabe zugrunde ein Leistungshalbleiterbauelement mit einer Feldringstruktur vorzustellen, wobei die Kontamination in weiten Bereichen des Diffusionsprofils vermieden wird.

Die Aufgabe wird erfindungsgemäß gelöst, durch die Maßnahmen des Anspruchs 1. Eine bevorzugte Ausführungsform ist in einem Unteranspruch beschrieben.

Der erfinderische Gedanke geht aus von einem Leistungshalbleiterbauelement mit einem Halbleitergrundkörper erster, als n- Dotierung ausgebildeten, Dotierung. Zur Ausbildung mindestens eines pn- Übergangs ist in diesem Grundkörper mindestens ein Bereich einer zweiten, als p- Dotierung ausgebildeten, Dotierung angeordnet, der im Folgenden als Kontaktbereich bezeichnet wird. Da dieser Bereich zweiter Dotierung vorzugsweise mittels eines Diffusionsprozesses ausgebildet ist, weist er keine homogene Dotierung sondern ein erstes Dotierungsprofil mit abnehmender Konzentration ausgehend von der Einbringfläche des Dotanten aus auf. Dieser Kontaktbereich ist auf einer ersten Teilfläche der ersten Oberfläche des Leistungshalbleiterbauelements angeordnet.

Weiterhin weist das erfindungsgemäße Leistungshalbleiterbauelement an einer zweiten Teilfläche der ersten Oberfläche eine Feldringstruktur ausgebildet als eine Mehrzahl von im Randbereich des Leistungshalbleiterbauelements angeordneten Feldringen auf. Diese Feldringe sind ebenfalls als Bereiche zweiter Dotierung und mit einem zweiten Dotierungsprofil ausgebildet und umschließen den Kontaktbereich vorzugsweise konzentrisch. Die Feldringe sind an einer ersten Oberfläche des Grundkörpers angeordnet und erstrecken sich wie der Kontaktbereich in das Volumen des Grundkörpers hinein.

Erfindungsgemäß weist der Grundkörper des Leistungshalbleiterbauelements für die Feldringstruktur jeweils eine dem jeweiligen Feldring zugeordnete grabenförmige Ausnehmung auf, deren Oberfläche im Wesentlichen der Kontur des zugeordneten zweiten Dotierungsprofils folgt. Der Halbleiterkörper weist ebenfalls eine grabenförmige Ausnehmung auf, in deren Bereich ein Kontaktbereich ausgebildet ist.

Ein besonders bevorzugtes Verfahren zur Herstellungen eines oben genannten Leistungshalbleiterbauelements umfasst folgende wesentliche Verfahrensschritte zur Ausbildung der Feldringe:
- Geeignete Ausbildung einer Mehrzahl von grabenförmigen Ausnehmungen (Gräben) im Bereich der späteren Feldringe im Bereich der ersten und zweiten Teilfläche der Oberfläche des Leistungshalbleiterbauelements; diese Gräben sind vorzugsweise konzentrisch um den Kontaktbereich des Leistungshalbleiterbauelements angeordnet;
- Maskierung der ersten und zweiten Teilfläche der Oberfläche des Leistungshalbleiterbauelements in denjenigen Bereichen in denen keine Gäben ausgebildet sind;
- Erzeugung des ersten und zweiten Dotierungsprofils zweiter Dotierung ausgehend von der ersten Oberfläche im Bereich der Gräben und somit Ausbildung der Feldringstruktur; diese Erzeugung erfolgt vorteilhafterweise mittels lonenimplantation;
- Vollständige Passivierung der ersten Teilfläche und somit auch der Oberfläche der Gräben der Feldringe.

Wesentlich bei diesem Verfahren ist, dass hierbei das Dotierungsprofil in einem zeitlich kürzeren Prozess erzeugt wird, wobei zudem das Kontaminationsrisiko gering ist.

Es wird somit gleichzeitig mit dem jeweiligen Verfahrensschritt zur Ausbildung der Feldringe im Bereich der ersten Teilfläche einen Graben und anschließend dessen Dotierungsprofil auszubilden, wodurch der pn-Übergang und somit der Kontaktbereich ebenfalls in einem eigenen Graben entsteht.

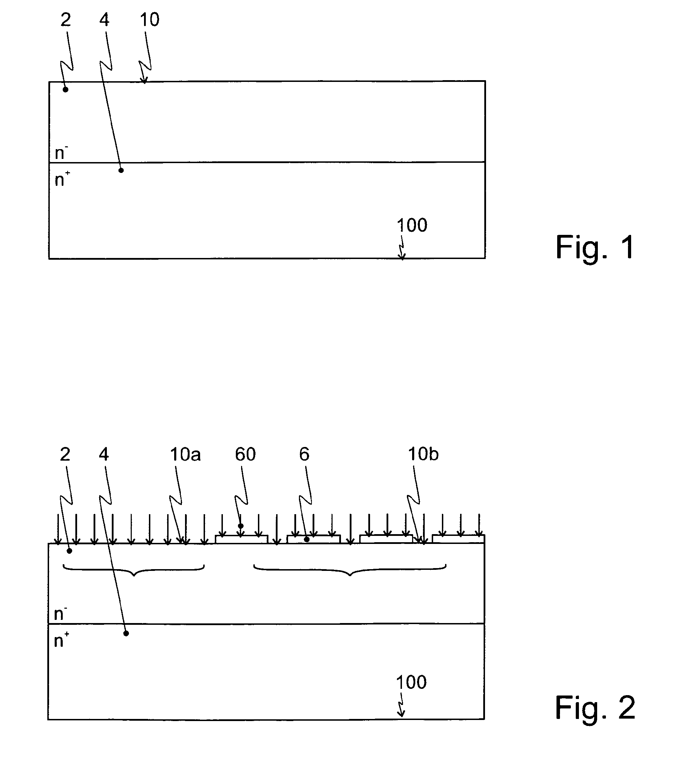

Die erfinderische Lösung wird an Hand zweier möglicher Herstellungsverfahren und mittels der Fig. 1 bis 6 weiter erläutert. Hierbei wird neben der Ausbildung der erfinderischen Feldringstruktur auch die Ausbildung eines bevorzugten Kontaktbereichs beschrieben. Dies ist vorteilhaft allerdings nicht beschränkend. Alternative Ausgestaltungen des Kontaktbereichs können ebenso bevorzugt sein.
Fig. 1 zeigt einen Grundkörper eines erfindungsgemäßen Leistungshalbleiterbauelements.
Fig. 2 zeigt einen Teilschritt eines ersten Verfahrens zur Ausbildung von Dotierprofilen zweiter Dotierung.
Fig. 3 zeigt ein Leistungshalbleiterbauelement nach Ausbildung der Dotierprofile im Rahmen des ersten Verfahrens.
Fig. 4 zeigt einen Teilschritt nach Ausbildung der Gräben der Feldringstruktur.
Fig. 5 zeigt einen Teilschritt zur Ausbildung des Dotierungsprofils der Feldringe im Rahmen eines zweiten Verfahrens.
Fig. 6 zeigt ein Leistungshalbleiterbauelement ausgebildet gemäß dem zweiten Verfahren.

Fig. 1 zeigt einen nicht maßstäblichen Ausschnitt des Grundkörpers (2, 4) eines erfindungsgemäßen als Leistungsdiode ausgebildeten Leistungshalbleiterbauelements für eine Sperrspannung von 1200V. Dieses Beispiel wird grundsätzlich auch für die folgenden Figuren beibehalten. Der Halbleitergrundkörper weist hierbei eine n-Dotierung mit zwei unterschiedliche Konzentrationen auf. An die ersten Oberfläche (10) des Grundkörpers schließt sich ein schwach dotierter Bereich (2) an, während an die zweite Oberfläche (100) ein stark dotierter Bereich (4) anschließt. Die Grenze der beiden Dotierungen verläuft im Inneren des Grundkörpers parallel zu den Oberflächen (10, 100).

Fig. 2 zeigt den Teilschritt, eines ersten Verfahrens, zur Ausbildung von Dotierprofilen zweiter Dotierung, sowohl für den Kontaktbereichs als auch für die Feldringstruktur. Gemäß dem Stand der Technik werden hier verschiedene Bereiche zur Vorbereitung des selektiven Dotierens maskiert (6). Im Bereich der ersten Teilfläche (10a) wird der Kontaktbereich, im Bereich der zweiten Teilfläche (10b) werden die Feldringe der Feldringstruktur entstehen. Die Dotierung mittels Diffusion (60) erfolgt hierbei gemäß dem Stand der Technik aus Richtung der ersten Oberfläche (10).

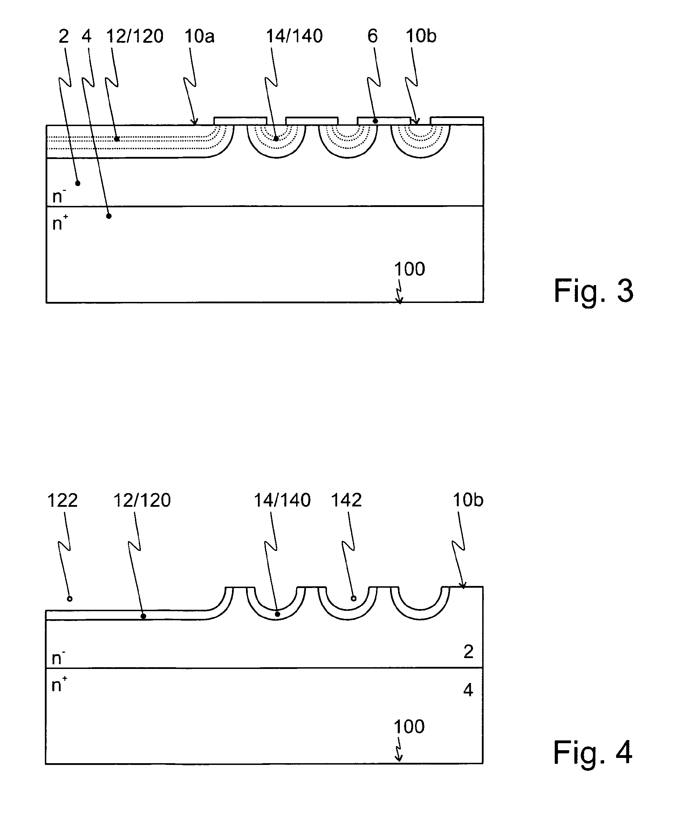

Fig. 3 zeigt den Teilschritt nach Ausbildung der zweiten, hier p- Dotierung. Weiterhin dargestellt ist der Verlauf der jeweiligen Dotierungsprofile (120, 140), also die Abnahme der Konzentration an p- Dotanten mit der Eindringtiefe. Es ist ersichtlich, dass die p- Dotanten nicht nur senkrecht zur Oberfläche (10) in den Halbleitergrundkörper (2, 4) eindringen, sondern auch längs der Oberfläche eindringen und bei genügen kleiner Öffnung der Maskierung (6) annähernd halbkreisförmige Bereiche ausbilden. Dies gilt in analoger Weise auch für die Ausbildung des Kontaktbereichs (12).

Fig. 4 zeigt den Teilschritt nach Ausbildung der Gräben (122, 142) sowohl für den Kontaktbereich (12) als auch für die Feldringe (14). Vorteilhafterweise werden diese Gräben mittels eines geeigneten Ätzmedium erzeugt, wobei sich die Oberfläche der Gräben im Wesentlichen entlang einer Konzentrationslinie der p-Dotierung (120) ausbildet. Somit entsteht ein schwach dotierter Kontaktbereich (12) und ebenso schwach dotierte Feldringe (14). Für die Wirkung der Feldringe (14) ist nur deren Übergangsbereich zur ersten Dotierung (2) wesentlich, daher werden durch die Ausbildung der Gäben (142) die elektrischen Eigenschaften des Leistungshalbleiterbauelements nicht wesentlich verändert.

Das erfindungsgemäße als Leistungsdiode ausgebildete Leistungshalbleiterbauelement weist eine Grundfläche im Bereich zwischen 10mm² und 100mm² und einer Sperrspannung von 1200V mit folgenden Größenordnungen auf:
- Die Dicke der Leistungsdiode beträgt zwischen 100µm und 450µm.
- Der pn- Übergang, also die Eindringtiefe der zweiten, hier der p-, Dotierung bzw. des Dosierprofils (120, 140) beträgt zwischen 10µm und 30µm.
- Die Tiefenausdehnung des Grabens (122, 142) beträgt maximal 90 von 100 und minimal 50 von 100 der Eindringtiefe der zweiten Dotierung. Bei einer Eindringtiefe von 20µm beträgt die Tiefe des Grabens somit zwischen 10µm und 18µm.
- Der Bereich zweiter Dotierung der Feldringe (14) weist an der Oberfläche eine bevorzugte Konzentration von 10¹⁵ bis 10¹⁶ cm⁻³ auf.
- Die laterale Ausdehnung der Gräben (142) der zugeordneten Feldringe (14) zur Tiefenausdehnung weist ein Verhältnis von 1 : 3 bis 3 : 1 auf.

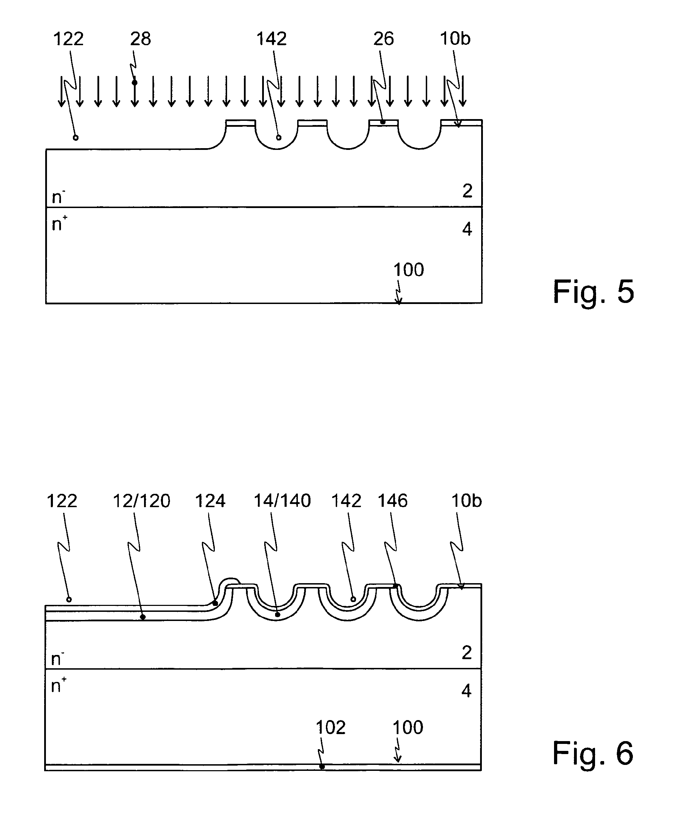

Fig. 5 zeigt einen Teilschritt zur Ausbildung des Dotierungsprofils der Feldringe (14) im Rahmen eines zweiten Verfahrens. Nach Ausbildung der Gräben (142) für die jeweils zugeordneten Feldringe (14) und des Grabens (122) für den Kontaktbereich (12) erfolgt die Maskierung (26) der Oberfläche (10) in denjenigen Bereichen in denen keine Gräben (122, 142) ausgebildet sind.

In einem nächsten Schritt erfolgt die lonenimplantation (28) aus Richtung der ersten Oberfläche (10). Vorteilhafterweise schließt sich an die lonenimplantation (28) noch ein Ausheilschritt zur Beseitigung von während der Implantation entstandener Kristalldefekte an.

Fig. 6 zeigt ein Leistungshalbleiterbauelement ausgebildet gemäß dem zweiten Verfahren. Die einzelnen Feldringe weise ihnen zugeordnete Gräben auf, wobei die Oberfläche jedes Grabens im Wesentlichen der Kontur seines Dotierungsprofils folgt.

Vorteilhafterweise ist noch eine Passivierung (146) gemäß dem Stand der Technik auf der zweiten Teilfläche (10b) und auf den Oberflächen der Gäben (142) der Feldringe (14) angeordnet. Ebenso weisen der Kontaktbereich (12) und die zweite Oberfläche (100) je eine Metallisierung (124, 102) zur elektrischen Kontaktierung auf.

Bei der Herstellung des erfindungsgemäßen Leistungshalbleiterbauelements wird die Eindringtiefe des ersten und zweiten Dotierungsprofils (120, 140) gleich ausgebildet, da somit der Kontaktbereich (12) und die Feldringstruktur (14) gemeinsam ausgebildet werden können.

## Patentansprüche

1. Leistungshalbleiterbauelement mit einem Halbleitergrundkörper (2, 4) erster Dotierung, einem in diesem Grundkörper in einer grabenförmigen Ausnehmung (122) ausgebildeten und mit dem Bereich erster Dotierung einen pn- Übergang ausbildenden Kontaktbereich (12) zweiter Dotierung mit einem ersten Dotierungsprofil (120) und einer Feldringstruktur (14) zweiter Dotierung mit einem zweiten Dotierungsprofil (140) des jeweiligen Feldrings, wobei die Eindringtiefe des ersten und zweiten Dotierungsprofils (120,140) gleich sind, wobei der Kontaktbereich (12) und die Feldringstruktur (14) an jeweils zugeordneten ersten (10a) und zweiten (10b) Teilflächen einer ersten Oberfläche (10) des Grundkörpers angeordnet sind und sich in das Volumen des Grundkörpers hinein erstrecken, und wobei der Grundkörper (2, 4) für die Feldringstruktur (14) eine dem jeweiligen Feldring zugeordnete grabenförmige Ausnehmung (142) aufweist, deren Oberfläche im Wesentlichen der Kontur des zugeordneten Dotierungsprofils (140) folgt, wobei die erste Dotierung als n-Dotierung und die zweite Dotierung als p-Dotierung ausgebildet ist,
wobei das Leistungshalbleiterbauelement als Leistungsdiode ausgebildet ist, **dadurch gekennzeichnet, dass** das Leistungshalbleiterbauelement eine Grundfläche im Bereich zwischen 10 mm² und 100 mm² aufweis, wobei die Dicke des Leistungshalbleiterbauelements zwischen 100 µm und 450 µm beträgt, wobei die Eindringtiefe der zweiten Dotierung (120,140) zwischen 10 µm bis 30 µm beträgt, wobei die Tiefenausdehnung der jeweiligen grabenförmigen Ausnehmung (122,142) maximal 90 von 100 und minimal 50 von 100 der Eindringtiefe der zweiten Dotierung beträgt, wobei der Bereich der zweiten Dotierung der Feldringe an der Oberfläche eine Konzentration von 10¹⁵ bis 10¹⁶ cm⁻³ aufweist, wobei die laterale Ausdehnung der grabenförmigen Ausnehmung (142) der zugeordneten Feldringe zur Tiefenausdehnung ein Verhältnis von 1 : 3 bis 3 : 1 aufweist.

2. Leistungshalbleiterbauelement nach Anspruch 1,
wobei die zweite Teilfläche (10b) einschließlich der grabenförmigen Ausnehmungen (142) mit einer Passivierungsschicht (146) bedeckt ist.

## Claims

1. Power semiconductor component comprising a semiconductor base body (2, 4) having a first doping, a contact region (12) having a second doping with a first doping profile (120), said contact region being formed in said base body in a trench-type cutout (122) and forming a pn junction with the region having the first doping, and a field ring structure (14) having a second doping with a second doping profile (140) of the respective field ring, wherein the penetration depth of the first and second doping profiles (120, 140) are identical, wherein the contact region (12) and the field ring structure (14) are arranged at respectively assigned first (10a) and second (10b) partial areas of a first surface (10) of the base body and extend into the volume of the base body, and wherein the base body (2, 4) has, for the field ring structure (14), a trench-type cutout (142) assigned to the respective field ring, a surface of said cutout essentially following the contour of the assigned doping profile (140), wherein the first doping is embodied as n-doping and the second doping is embodied as p-doping, wherein the power semiconductor component is embodied as a power diode, **characterized in that** the power semiconductor component has a basic area in the range of between 10 mm² and 100 mm², wherein the thickness of the power semiconductor component is between 100 µm und 450 µm, wherein the penetration depth of the second doping (120, 140) is between 10 µm and 30 µm, wherein the depth extent of the respective trench-type cutout (122, 142) is a maximum of 90 per cent and a minimum of 50 per cent of the penetration depth of the second doping, wherein the region of the second doping of the field rings has a concentration of 10¹⁵ to 10¹⁶ cm⁻³ at the surface, wherein the lateral extent of the trench-type cutout (142) of the assigned field rings with respect to the depth extent has a ratio of 1:3 to 3:1.

2. Power semiconductor component according to Claim 1,
wherein the second partial area (10b) including the trench-type cutouts (142) is covered with a passivation layer (146).

## Revendications

1. Composant semi-conducteur de puissance comprenant un corps de base semi-conducteur (2, 4) présentant un premier dopage, une région de contact (12) présentant un deuxième dopage réalisée dans ce corps de base dans un évidement en forme de tranchée (122) et constituant avec la région présentant le premier dopage une transition pn, avec un premier profil de dopage (120) et une structure de bague de champ (14) présentant un deuxième dopage avec un deuxième profil de dopage (140) de la bague de champ respective, la profondeur de pénétration des premier et deuxième profils de dopage (120, 140) étant identique, la région de contact (12) et la structure de bague de champ (14) étant disposées au niveau de première (10a) et deuxième (10b) surfaces partielles respectivement associées d'une première surface (10) du corps de base et s'étendant dans le volume du corps de base, et le corps de base (2, 4) pour la structure de bague de champ (14) présentant un évidement (142) en forme de tranchée associé à la bague de champ respective, dont la surface suit essentiellement le contour du profil de dopage associé (140), le premier dopage étant réalisé sous forme de dopage n et le deuxième dopage étant réalisé sous forme de dopage p, le composant semi-conducteur de puissance étant réalisé sous forme de diode de puissance,
**caractérisé en ce que**
le composant semi-conducteur de puissance présente une surface de base dans une plage comprise entre 10 mm² et 100 mm²,
l'épaisseur du composant semi-conducteur de puissance étant comprise entre 100 µm et 450 µm, la profondeur de pénétration du deuxième dopage (120, 140) étant comprise entre 10 µm et 30 µm, l'étendue en profondeur de l'évidement en forme de tranchée respectif (122, 142) étant au maximum de 90 pour 100 et au minimum de 50 pour 100 de la profondeur de pénétration du deuxième dopage, la région du deuxième dopage des bagues de champ au niveau de la surface présentant une concentration de 10¹⁵ à 10¹⁶ cm⁻³, l'étendue latérale de l'évidement en forme de tranchée (142) des bagues de champ associées par rapport à l'étendue en profondeur présentant un rapport de 1 : 3 à 3 : 1.

2. Composant semi-conducteur de puissance selon la revendication 1,
dans lequel la deuxième surface partielle (10b), y compris les évidements en forme de tranchée (142), est recouverte d'une couche de passivation (146).
